# EUROPEAN PATENT APPLICATION

(11) **EP 1 223 622 A2**
(43) Date of publication of application: **17.07.2002**
(21) Application number: 01308381.1
(22) Date of filing: 01.10.2001
(51) Int. Cl.: H01L 27/115

(54) **Semiconductor device and method for fabrication thereof**

(30) Priority: 11.01.2001 JP 2001004150
(71) Applicant: FUJITSU LIMITED, Kawasaki-shi, Kanagawa 211-8588 (JP)
(72) Inventor: Maruyama, Kenji, c/o Fujitsu Limited, Kawasaki-shi, Kanagawa 211-8588 (JP); Kurihara, Kazuaki, c/o Fujitsu Limited, Kawasaki-shi, Kanagawa 211-8588 (JP)
(74) Representative: Silverman, Warren

(57) **Abstract**

A semiconductor device which comprises a first electrode 32, a ferroelectric film 36 formed above the first electrode, and a second electrode 40 formed above the ferroelectric film, further comprises intermediate layers 34, 38 formed at at least one of the boundary between the first electrode and the ferroelectric film, and the boundary between the ferroelectric film and the second electrode, such intermediate layer(s) having a perovskite crystal structure. Because such intermediate layers having perovskite crystal structure are formed between the first and/or second electrodes and the ferroelectric film, even when a base metal is used as a material for the bottom and/or top electrode of a ferroelectric capacitor, the ferroelectric film can have crystal structure exhibiting ferroelectricity. Base metals can be used as materials for the bottom and top electrodes of the ferroelectric capacitor to decrease the cost of semiconductor devices. Materials which it has been difficult to use for the bottom and top electrodes of a ferroelectric capacitor can now be used to simplify the fabrication processes and improve electric characteristics.

## Description

The present invention relates to a semiconductor device and a method for fabricating the semiconductor device, more specifically a semiconductor device including capacitors.

A FRAM (Ferro-electric Random Access Memory) is a nonvolatile semiconductor memory using a ferroelectric film as the dielectric of the capacitors. FRAMS have rewriting speed as high as tens of nanoseconds and has good repeatability of 1x10¹⁰ to 1x10¹² rewritable times. Furthermore, FRAMS have small electric power consumptions. Because of these factors, FRAMS have considerable potential. FRAMS which can retain data when power supply is absent are expected to be applied to various uses, such as memories of portable instruments, etc.

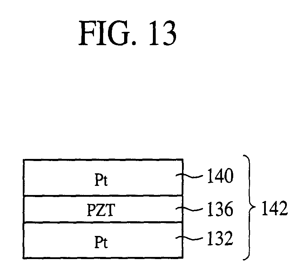

The structure of the capacitor of a FRAM will be explained with reference to FIG. 13. FIG. 13 is a conceptual view of a capacitor of a conventional FRAM.

A bottom electrode 132 is formed on a silicon substrate (not shown) through a silicon oxide film, (also not shown). A ferroelectric film 136 is formed on the bottom electrode 132. A top electrode 140 is formed on the ferroelectric film 136.

The bottom electrode 132, the ferroelectric film 136 and the top electrode 140 constitute the capacitor 142 of the FRAM.

The ferroelectric film 136 of such capacitors 142 can be a PZT (PbZr_{X}Ti_{1-X}O₃) film, a SBT (SrBi₂Ta₂O₉) film or others.

For example, in a case of a ferroelectric film 136 of PZT, it is necessary to subject the PZT film to high-temperature thermal processing at about 600 °C to be crystallized into a perovskite structure, which exhibits ferroelectricity.

Accordingly, the bottom electrode 132 and the top electrode 140 of the capacitors are formed of Pt, Ir or others, which have strong self-orientation and low reactivity.

Pt, Ir, etc. are materials which tend to be self-oriented in (111). Where the bottom electrode and the top electrode are formed of such materials, crystal directions of the surfaces of the bottom electrode and the top electrodes can be easily aligned. Accordingly, in such cases, crystal directions of the ferroelectric film can be easily aligned, and the ferroelectric film can have good perovskite crystal structure. Furthermore, Pt, Ir, etc. are not easily oxidized by heat processing at high temperatures. Conventionally Pt, Ir, etc. have been used as materials of the bottom electrode 132 and the top electrode 140 of the capacitors.

However, Pt, Ir, etc. are noble metals and expensive to use for forming the bottom electrode and the top electrode and their market prices are not constant. This has been a barrier to low costs of the semiconductor devices. These unreactive metals, as opposed to base metals generally do not easily undergo chemical changes, are not easily oxidized by heating in air and have low ionization tendency.

However, hitherto, the materials forming the bottom electrode and the top electrode of the capacitors have been restrictively limited to Pt, Ir, etc. This has been a barrier to simplification of the fabrication process and further improvement of electric characteristics.

An object of the present invention is to provide a semiconductor device and a method for fabricating the semiconductor device at relatively low cost.

According to one aspect of the present invention, there is provided a semiconductor device comprising a first electrode, a ferroelectric film formed above the first electrode, and a second electrode formed above the ferroelectric film, further comprising an intermediate layer of perovskite crystal structure formed at at least one of the boundary between the first electrode and the ferroelectric film and the boundary between the ferroelectric film and the second electrode. As a result of intermediate layers having perovskite crystal structure being formed between the first electrode and the ferroelectric film and/or between the ferroelectric film and the second electrode, even in a case that a base metal is used as a material of the bottom and/or top electrode of a ferroelectric capacitor, the ferroelectric film can have crystal structure exhibiting ferroelectricity. Base metals can be used as a material of the bottom electrode and the top electrode of the ferroelectric capacitor, which decreases costs of semiconductor devices. Materials which have previously been unsuitable to use for the top and bottom electrodes of a ferroelectric capacitor can now be used in a simple fabrication processes whereby a capacitor having improved electric characteristics is produced.

According to another aspect of the present invention, there is provided a semiconductor device comprising a capacitor according to the first aspect of the invention and a transistor connected to the first electrode or the second electrode.

According to a further aspect of the present invention, there is provided a method for fabricating a semiconductor device comprising the step of forming a first electrode, the step of forming a ferroelectric film above the first electrode, and the step of forming a second electrode above the ferroelectric film, further comprising the step of forming an intermediate layer which is crystallizable into perovskite structure after the step of forming the first electrode and before the step of forming the ferroelectric film and/or after the step of forming the ferroelectric film and before the step of forming the second electrode.

As described above, according to the present invention, intermediate layers are each formed between the bottom electrode and the ferroelectric film and between the ferroelectric film and the top electrode. The intermediate layer is formed of a material which, even in a case that the intermediate layer is formed on the bottom electrode of a material of weak self-orientation, can be crystallized into perovskite structure. In a case that the materials of the bottom and top electrodes are base metals, the intermediate layer is formed of a material which can prevent oxidation of the bottom electrode and the top electrode, and furthermore can depress transition of elements in the ferroelectric film into the bottom electrode and the top electrode. Accordingly, the intermediate layers allow the ferroelectric film to have crystal structure exhibiting ferroelectricity even in a case that materials of weak self-orientation, such as base metal, are used as materials of the bottom and top electrodes of a ferroelectric capacitor. According to the present invention, inexpensive base metals can be used as materials of the bottom and top electrodes of a ferroelectric capacitor, whereby semiconductor devices can have low costs.

According to the present invention, materials which have been difficult to be used as materials of the bottom electrode and the top electrode of a ferroelectric capacitor can be used, whereby fabrication processes can be further simplified, and electric characteristics can be improved.

For a better understanding of the present invention, reference will now be made by way of example to the accompanying drawings in which:-
FIGS. 1A and 1B are sectional views of the semiconductor device according to a first embodiment of the present invention.
FIGs. 2A to 2C are sectional views of the semiconductor device of FIG. 1A at early stages during the manufacture thereof.
FIGS. 3A and 3B are sectional views of the semiconductor device of FIG. 1A at later stages during te manufacture thereof.
FIGs. 4A and 4B are sectional views of the semiconductor device of FIG. 1A at later stages during the manufacture thereof.
FIG. 5 is a sectional view of the semiconductor device of FIG. 1A during the final stage in the manufacture thereof.
FIGs. 6A to 6C are schematic sectional views of semiconductor devices embodying the invention which are variant of that shown in FIG. 1B.
FIGs. 7A to 7C are schematic sectional views of further semiconductor devices embodying the invention which are also variants of that shown in FIG. 1B of the present invention.
FIGs. 8A and 8B are sectional views of a semiconductor device according to a second embodiment of the present invention.
FIGs. 9A and 9B are sectional views of the second semiconductor device at different steps in the fabrication thereof.
FIGs. 10A and 10B are sectional views of a third semiconductor device embodying this invention.
FIGs. 11A and 11B are sectional views of the third semiconductor device at stages during the fabrication thereof.
FIGs. 12A and 12B are sectional views of variants of the semiconductor device according to the present invention.
FIG. 13 is a conceptual view of a capacitor of the conventional FRAM.

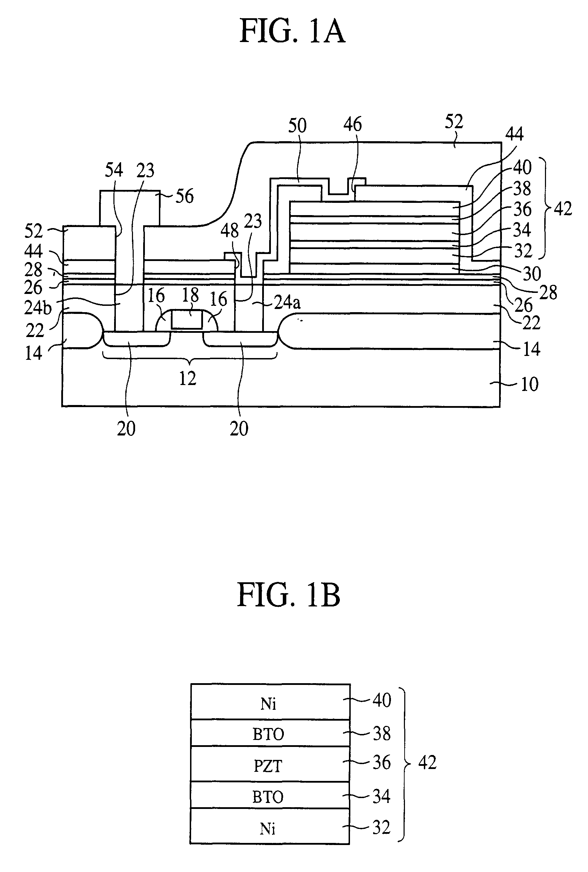

The semiconductor device according to a first embodiment of the present invention and a method for fabricating the same will be explained with reference to FIGs. 1A to 5. In general, the term semiconductor device is used to denote both a capacitor 42, 42a etc which embodies, in itself, the inventive principle and also an overall device which incorporates such a capacitor.

As shown in FIGs. 1A and 1B, an element isolation film 14 for defining element regions 12 is formed on a silicon substrate 10. In the element regions 12 defined by the element isolation film 14, transistors are formed including gate electrodes 18 having a sidewall insulation film 16 formed on the side walls and a source/drain diffused layer 20.

Furthermore, an inter-layer insulation film 22 of 600 nm-thickness silicon oxide film is formed on the entire surface. Contact holes 23 are formed in the inter-layer insulation film 22 down to the source/drain diffused layer 20. Conductor plugs 24a, 24b are formed in the contact holes 23.

A 100 nm-thick silicon oxide nitride stopper film 26 is formed on the inter-layer insulation film 22. A 250 nm-thick silicon oxide film 28 is formed on the stopper film 26.

A 200 nm-thick TiN adhesion layer film 30 is formed on the silicon oxide film 28. A 100 nm-thick Ni bottom film electrode 32 is formed on the adhesion layer 30.

A 20 nm-thick BTO (BaTiO₃) intermediate film layer 34 is formed on the bottom electrode 32. BTO is a dielectric having perovskite crystal structure.

A 200 nm-thick PZT (PbZr_{X}Ti_{1-X}O₃) ferroelectric film 36 is formed on the intermediate layer 34. PZT is a Pb-containing oxide ferroelectric having perovskite crystal structure, i.e., a lead-based oxide ferroelectric.

A 20 nm-thick BTO intermediate film layer 38 is formed on the ferroelectric film 36. An 80 nm-thick Ni top electrode film is formed on the intermediate layer 38.

The bottom electrode 32, the intermediate layer 34, the ferroelectric film 36, the intermediate layer 38 and the top electrode 40 constitute a capacitor 42 for a memory device.

A 300 nm-thick silicon oxide film 44 is formed on the entire surface. Contact holes 46 extend to the top electrode 40, and a contact hole 48 which extends to the conductor plug 24a are formed in the silicon oxide film 44.

An interconnection layer 50 interconnecting the top electrode 40 and the conductor plug 24a via the contact holes 46, 48 is formed on the silicon oxide film 44.

A 300 nm-thickness silicon oxide inter-layer insulation film 52 is formed on the entire surface. A contact hole 54 which extends to the conductor plug 24b is formed in the inter-layer insulation film 52, the silicon oxide films 44, 28 and the stopper film 26.

A bit line 56 formed on the inter-layer insulation film 52 is connected to the conductor plug 24b via the contact hole 54.

A semiconductor device according to the present embodiment is characterized mainly in that the bottom electrode 32 and the top electrode 40 are formed of Ni, a base metal, and the intermediate layers 34, 38 each of BTO are formed respectively between the bottom electrode 32 and the ferroelectric film 36 and between the ferroelectric film 36 and the top electrode 40. The term base metal has opposite significance to the term noble metal, and generally means metals which are not chemically stable, tend to be oxidized by heating in air and have high ionization tendency.

Pt, Ir, etc. are materials which tend to be self-oriented, and when the bottom electrode and the top electrode are formed of such material, the crystal directions of the surfaces of the bottom electrode and the top electrode can be easily aligned. Accordingly, when the bottom electrode and the top electrode are formed of Pt, Ir or others, crystal directions of the ferroelectric film can be easily aligned, which makes it possible for the ferroelectric film to exhibit good ferroelectricity and have perovskite crystal structure. Pt, Ir, etc. are not easily oxidized by thermal processing even at high temperatures. Accordingly, Pt. Ir, etc. have been used as materials of bottom electrodes 132 and top electrodes 140 in the capacitors as shown in FIG. 13.

In contrast to this, base metals, such as Ni, are materials which are not easily self-aligned, and in a case that the bottom and top electrode are formed of such material, crystal directions of the surfaces of the bottom and top electrode are not easily aligned. Accordingly, in the case that the bottom and top electrodes are formed of base metals, such as Ni or others, the ferroelectric film cannot have crystal directions easily aligned, and consequently it is difficult to have good perovskite crystal structure.

Furthermore, Pb and oxygen in a PZT film tend to be diffused into base metals. When base metals such as Ni, etc. are used as materials of the bottom and top electrodes, the thermal processing for crystallizing the PZT film diffuses Pb and oxygen into the bottom and top electrodes to cause defects of Pb and oxygen in the PZT film. When defects of Pb and oxygen are caused in PZT film, the PZT film is not easily crystallized into a perovskite structure. Accordingly, a good ferroelectric film cannot be obtained. In view of this it has been difficult to use base metals, such as Ni, etc., as materials of the bottom and top electrodes of a ferroelectric capacitor.

Furthermore, if base metals, such as Ni are used as materials of the bottom and top electrodes, they become oxidized by oxygen in the PZT film. In view of this, too, it has been difficult to use base metals, such as Ni, etc., as materials of the bottom and top electrodes of the ferroelectric capacitor.

As described above, conventionally Pt, Ir, etc., which are expensive unreactive metals, have been unavoidably used. That has been a bar to cost reduction in semiconductor devices. Materials which can be used as bottom and top electrodes of the ferroelectric capacitor have been narrowly limited to Pt, Ir, etc., which has also been a bar to simplification of fabrication processes and further improvement of electric characteristics.

The present embodiment solves these problems by forming the intermediate layers 34, 38 of, for example, BTO having the following characteristics between the bottom electrode 32 and the ferroelectric film 36 and between the ferroelectric film 36 and the top electrode 40.

The Curie temperature of a BTO film is not sufficiently high. It is difficult to use BTO film alone as the ferroelectric film to form the ferroelectric capacitor having good temperature characteristics. On the other hand, a BTO film has a characteristic that even in a case that BTO film is formed directly on a base metal bottom electrode of a base metal formed of, for example, Ni, the BTO film can form perovskite crystals by thermal processing in an inert atmosphere.

Furthermore, a BTO film has a characteristic of being able to depress diffusion of Pb and oxygen in the PZT film into the bottom or top electrodes of base metals, such as Ni. Accordingly, the intermediate layers of BTO are formed respectively between the bottom electrode and the PZT film and between the PZT film and the top electrode to thereby prevent the PZT film from losing the ferroelectricity and also prevent the bottom electrode and top electrodes from being oxidized.

As described above, according to the present embodiment, the intermediate layers of BTO having the above-described characteristics are formed respectively between the bottom electrode and the ferroelectric film and between the ferroelectric film and the top electrode, whereby even when base metals, such as Ni, are used as materials of the bottom and/or top electrodes ferroelectric films exhibiting ferroelectricity and perovskite crystal structure can be formed. According to the present embodiment, the bottom and top electrodes of the ferroelectric capacitor can be formed of base metals, such as Ni, whereby the semiconductor device can have low cost.

According to the present embodiment, base metals, such as Ni, which have been difficult to use in the past are used as materials of the bottom and top electrodes, whereby the fabrication process can be simplified, and electric characteristics can be improved.

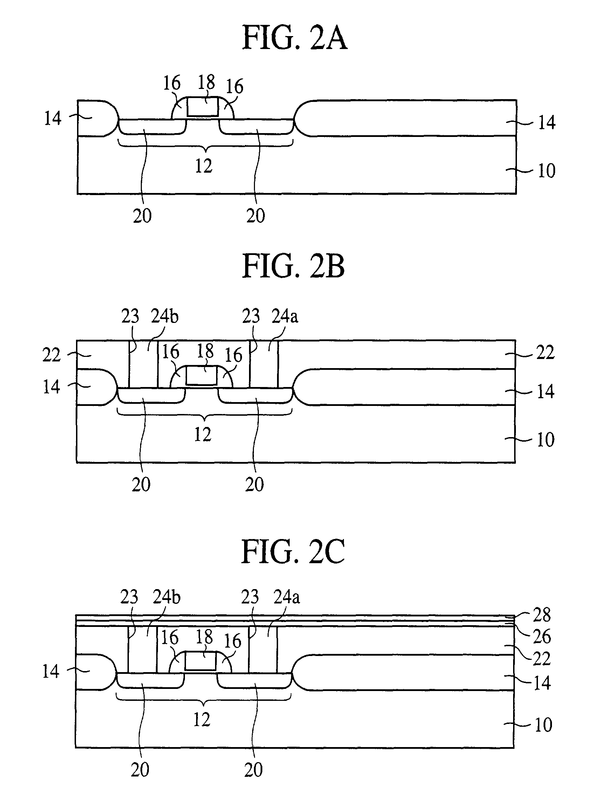

The method for fabricating the semiconductor device of FIG. 1A to the present embodiment will be explained with reference to FIGs. 2A to 5.

First, as shown in FIG. 2A, the element isolation film 14 is formed on the surface of a silicon substrate 10 by LOCOS (LOCal Oxidation of Silicon) to define element regions 12.

Then, transistors each including a gate electrode 18 with a sidewall insulation film 16 formed on the side wall, and a source/drain diffused layer 20 is formed in the element regions 12.

As shown in FIG. 2B, the 600 nm-thick inter-layer insulation film 22 of silicon oxide is formed on the entire surface by CVD (Chemical Vapor Deposition), and the surface of the inter-layer insulation film 22 is planarized by CMP (Chemical Mechanical Polishing).

Contact holes 23 are formed by photolithography through the inter-layer insulation film 22 down to the source/drain diffused layer 20.

Next, a 20 nm-thick Ti film and a 50 nm-thick TiN film are sequentially formed on the entire surface by sputtering to form an adhesion layer (not shown) of the Ti film and the TiN film. Next, a 600 nm-thick tungsten layer (not shown) is formed on the entire surface by CVD. Thus, the adhesion layer and the tungsten layer are formed on the inter-layer insulation film 22 and in the contact holes 23.

The tungsten layer and the adhesion layer are polished until the surface of the inter-layer insulation film 22 is exposed by CMP to form the conductor plugs 24a, 24b of the adhesion layer and the tungsten layer buried in the contact holes 23.

As shown in FIG. 2C, the 100 nm-thick silicon oxide nitride stopper film 26 is formed on the entire surface by CVD.

Then, the 250 nm-thick silicon oxide film 28 is formed on the entire surface.

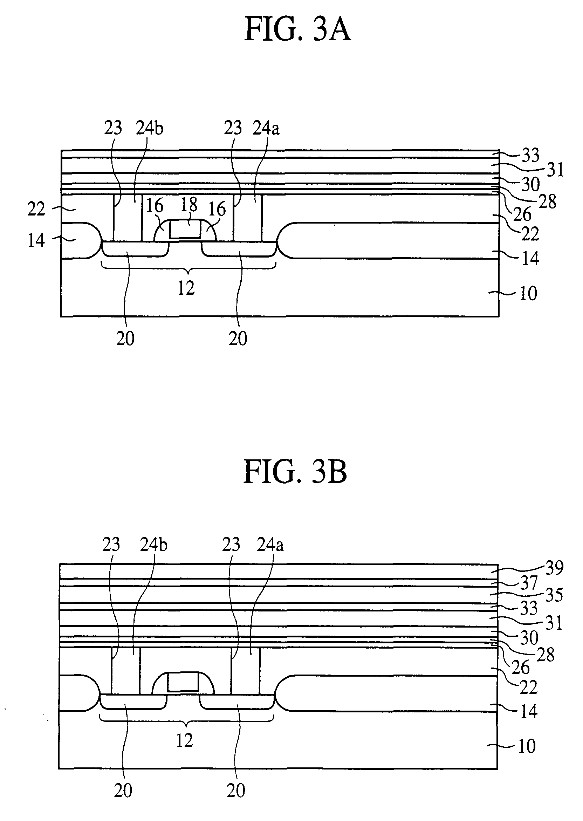

Then, as shown in FIG. 3A, the 200 nm-thick TiN adhesion film layer 30 is formed on the entire surface by sputtering.

A 100 nm-thick Ni film 31 for forming the bottom electrode 32 is formed in an inert atmosphere by sputtering using argon ion beams.

The 20 nm-thick BTO (BaTiO₃) film for providing the intermediate layer 34 is formed on the entire surface in an inert atmosphere by sputtering using argon ion beams. Film forming conditions can be, e.g., 10 sccm Ar gas flow rate, 3 Pa vacuum degree, 1.5 W applied electric power, 20 second-sputtering time, and 20 to 200 °C film forming temperature. The BTO film 33 is formed in an inert atmosphere for the purposes of preventing oxidation of the bottom electrode of Ni and forming the BTO film of a required composition. Sputtering gives the target high transient stability, and the BTO film 33 can be formed with a required composition stabilized.

The BTO film 33 is formed continuously without exposure to the ambient atmosphere after the Ni film 31 has been formed, so that the surface of the Ni film 31 is not contaminated, and no natural oxide film is formed on the surface of the Ni film 31. When exposure to the ambient atmosphere is performed after the step of forming the Ni film 31 and before forming the BTO film 33, the step of cleaning the surface of the Ni film 31 is necessary. However, when the BTO film 33 is formed without exposure to the ambient atmosphere, continuously after the Ni film 31 has been formed, the step of cleaning the surface of the Ni film 31 is unnecessary. For forming the BTO film 33 after the Ni film 31 has been formed, continuously without exposure to the ambient atmosphere, a cluster tool may be used.

The BTO film 33 may be formed by the sol-gel process. The sol-gel process is a wet film-forming-method using an organic metal solution as a raw material. The sol-gel process allows the mixing ratio of the raw materials to be suitably changed, and the composition of the BTO film can be finely adjusted.

However, when the BTO film 33 is formed by sol-gel process, a cluster tool cannot be used. Accordingly it is difficult to form the BTO film 33 after the Ni film 31 has been formed, without exposure to ambient atmosphere. When the BTO film 33 is formed by the sol-gel process, the step of cleaning the surface of the Ni film 31 before forming the BTO film 33 is necessary.

As shown in FIG. 3B, a 200 nm-thick PZT (PbZr_{X}Ti_{1-X}O₃) film 35 for providing the ferroelectric film 36 is formed on the entire surface without exposure to ambient atmosphere by sputtering using argon ion beams. Film forming conditions can be, e.g., 100 sccm Ar gas flow rate, 3 Pa vacuum degree, 2 kW applied electric power, 5 minute sputtering time, and 20 to 200 °C film forming temperature. The PZT film 35 is formed in an inert atmosphere for the purposes of preventing the composition of the BTO film from changing and for providing a PZT film of a required composition. The PZT film 35 is formed continuously without exposure to the ambient atmosphere after the BTO film 33 has been formed for the prevention of contamination, etc. of the surface of the BTO film 33.

PZT film 35 is formed on the BTO film 33 which has not been crystallized in a perovskite structure. This causes no special problem, because the BTO film 33, the PZT film 35, etc. can be crystallized together into a perovskite structure by the thermal processing which will be described later.

The PZT 35 may be formed by the sol-gel process. When the PZT film 35 is formed by the sol-gel process, it is difficult to form the PZT film 35 continuously after the BTO film 33 has been formed, without exposure to the ambient atmosphere.

Next, a 20 nm-thick BTO film 37 for providing the intermediate layer 38 is formed on the entire surface under an inert atmosphere without exposure to ambient atmosphere for the prevention of contaimination etc of the surface of the ferroelectric film 36 by sputtering using argon ion beams. The BTO film 37 can be formed under, e.g., the same conditions for forming the BTO film 33.

The BTO film 37, like the BTM film 33, can be formed by sol-gel process. However, when the BTO film 37 is formed by the sol-gel process, it is difficult to form the BTO film 37 continuously after the ferroelectric film 35 has been formed, without exposure to the ambient atmosphere.

An 80 nm-thick Ni film 39 for forming the top electrode 40 is formed on the entire surface in an inert atmosphere without exposure to ambient atmosphere by sputtering using argon ion beams.

The Ni film 39 is formed continuously after the BTO film 37 has been formed, without exposure to the ambient atmosphere, so as to prevent the surface of the BTO film 37 from being contaminated.

Next, 10 minute-thermal processing of 600 °C is repeated three times in an inert atmosphere. An inert atmosphere can be, e.g., Ar gas. This thermal processing crystallizes the BTO film 33, the PZT film 35 and the BTO film 37 into perovskite structure. The thermal processing is made in an inert atmosphere for the purpose of preventing, for good perovskite structure crystallization, compositions of the BTO film 33, the PZT film 35, the BTO film 37, etc. from changing.

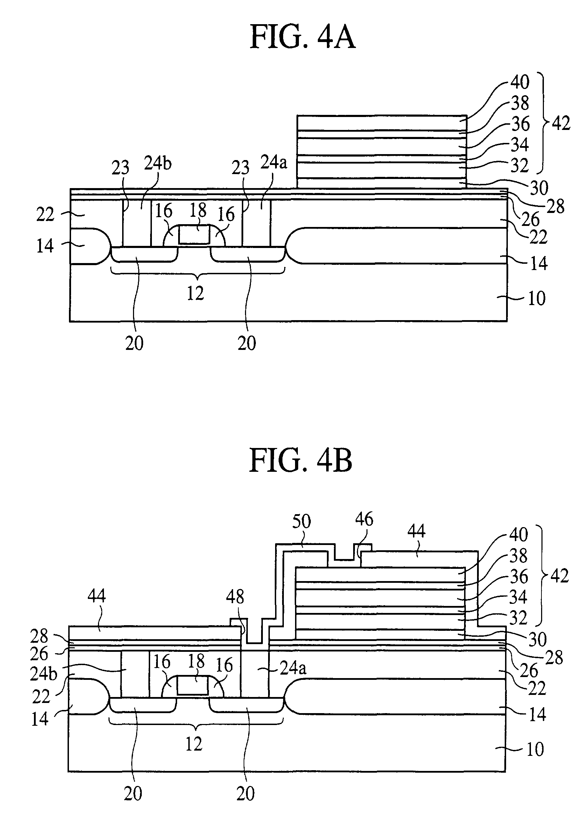

As shown in FIG. 4A, the Ni film 39, the BTO film 37, the PZT film 35, the BTO film 33, the Ni film 31 and the adhesion layer 30 are patterned by using photolithography and dry etching. Thus, the capacitor 42 comprises the bottom electrode 32 of the Ni film 31, the intermediate layer 34 of the BTO film 33, the ferroelectric film 36 of the PZT film 35, the intermediate layer 38 of the BTO film 37 and the top electrode 40 of the Ni film 39.

As shown in FIG. 4B, a 300 nm-thick silicon oxide film 44 is formed on the entire surface.

The contact hole 46 is formed in the silicon oxide film 44 down to the top electrode 40 by photolithography, and contact hole 48 is formed in the silicon oxide films 44, 28 and the stopper film 26 down to the conductor plug 24a.

A TiN film is formed on the entire surface. Then, the TiN film is patterned by photolithograpy to form the interconnection layer 50 interconnecting the top electrode 40 and the conductor plug 24a via the contact holes 46, 48.

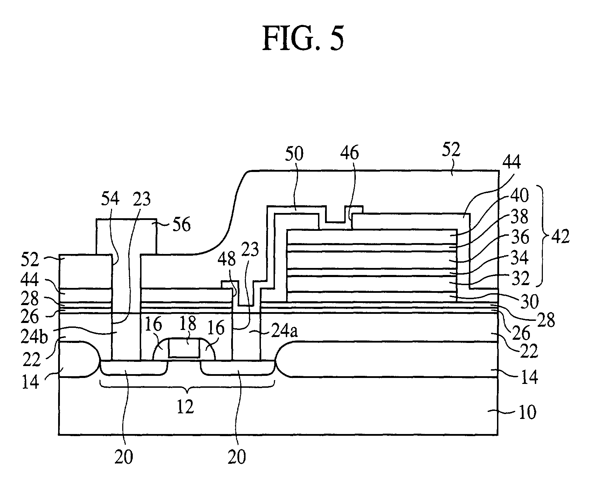

As shown in FIG. 5, the inter-layer insulation film 52 of a 300 nm-thick silicon oxide film is formed on the entire surface.

Then, a contact hole 54 is formed in the inter-layer insulation film 52, the silicon oxide films 44, 28 and the stopper film 26 down to the upper surface of the conductor plug 24b by photolithography.

A 600 nm-thick Al film is formed on the entire surface. Then, the Al film is patterned by photolithography to form the bit line 56 connected to the conductor plug 24b via the contact hole 54.

Thus, the semiconductor device according to the present embodiment is fabricated. The resulting device is that of Figure 1.

Modifications of the method for fabricating the semiconductor device according to the present embodiment will be explained with reference to FIGs. 2A to 5.

The semiconductor fabrication method according to the present modification is characterized in that the thermal processing for crystallizing the BTO film 33 into a perovskite structure occurs when the BTO film 33 has been formed, and the thermal processing for crystallizing the PZT film 35 and the BTO film 37 occurs after the PZT film 35, the BTO film 37 and the Ni film 39 have been formed.

The fabrication steps up to the step of forming the BTO film 33 including the BTO film 33 forming step are the same as those of the semiconductor device fabrication method which has been explained above with reference to FIGs. 2A to 3A, and their explanation is not repeated.

Then, 10 minute-thermal processing of 600 °C is repeated three times in an inert atmosphere. An inert atmosphere can be, e.g., Ar gas (see FIG. 3A).

Then, in the same way as in the semiconductor device fabrication method explained above with reference to FIG. 3B, the PZT film 35, the BTO film 37 and the Ni film 39 are sequentially formed.

A 5 minute-thermal processing of 600 °C is repeated three times in an inert atmosphere. An inert atmosphere can be, e.g., Ar gas.

The final fabrication steps of the semiconductor device fabrication method according to the present modification are the same as those of the semiconductor device fabrication method explained above with reference to FIGs. 4A to 5, and their explanation is not repeated.

Thus, the semiconductor device of FIG. 5 according to the present embodiment is fabricated by a variant semiconductor device fabrication method.

The semiconductor device shown in FIGs. 1A and 1B is thus fabricated by conducting, thermal processing to crystallize the BTO film 33 into the perovskite structure after the BTO film has been formed by conducting the thermal processing to crystallize the PZT film 35 and the BTO film 37 into the perovskite structure after the PZT film 35, the BTO film 37 and the Ni film 39 have been formed.

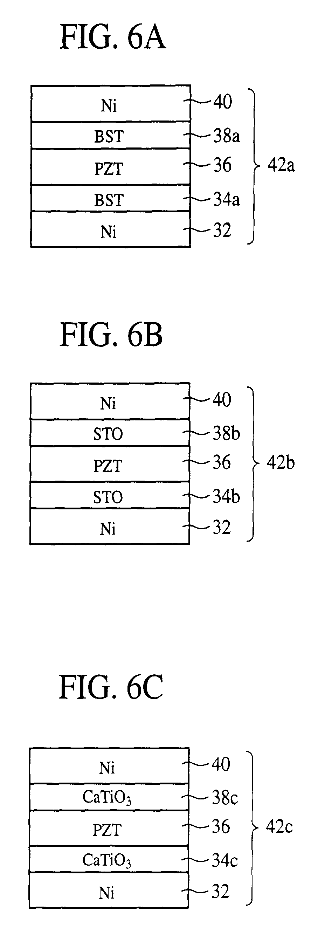

Modifications of the semiconductor device according to the present invention will first be explained with reference to FIGS. 6A. to 6C and 7A to 7C constituent members of the overall device, but for the capacitor, are omitted.

The capacitor 42a of FIG. 6A is characterized mainly in that an intermediate layer 34a and an intermediate layer 38a are formed of BST (BaₓSr₁₋ₓTiO₃).

A BST film has similar characteristics to a BTO (BaTiO₃) film. It is difficult to form a ferroelectric capacitor having good temperature characteristics by using only BST film, whose Curie temperature is not sufficiently high. On the other hand, BST film has the characteristic that even when BST film is formed directly on the bottom electrode of a base metal whose self-orientation is weak, such as Ni or others, the BST film can be crystallized into perovskite structure by thermal processing. The BST film, like BTO film, is able to depress diffusion of Pb and oxygen within the PZT film into the bottom and top base metal electrodes formed, for example, of Ni.

Thus, even when BST is used as material of the intermediate layers, a ferroelectric capacitor using base metals as materials of the bottom electrode and top electrode can be formed.

The capacitor 42b shown in FIG. 6B is characterized mainly in that STO (SrTiO₃) is used as a material of intermediate layers 34b, 38b. STO film has similar characteristics to BTO film.

Accordingly, even in a case that STO film is used as a material of the intermediate layers as in the present modification, a ferroelectric capacitor can be produced using base metals as materials for the bottom and top electrodes.

The capacitor 42c shown in FIG. 6C is characterized mainly in that CaTiO₃ film is used as a material of intermediate layers 34c, 38c. CaTiO₃ film also has similar characteristics to BTO film.

Accordingly, even in a case that CaTiO₃ film is used the material of the intermediate layers, a ferroelectric capacitor, can be produced using base metals as materials for the bottom and top electrodes.

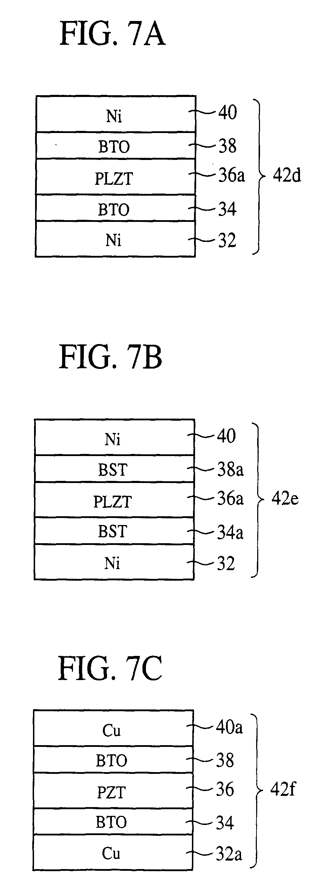

The capacitor 42d shown in FIG. 7A is characterized mainly in that PLZT ((Pb_{1-Y}La_{Y}) (Zr_{1-X}Ti_{X})O₃), which is PZT with La added, is used as the material of the ferroelectric film. PLZT film like PZT film is a lead-based oxide ferroelectric film having perovskite crystal structure, which exhibits ferroelectricity.

In the present modification, PLZT is used as a material of the ferroelectric film for the particular purpose of depressing depletion of oxygen from the ferroelectric film when thermal processing is carried out under a hydrogen atmosphere.

In the general semiconductor fabrication process, thermal processing is often carried out under a hydrogen atmosphere. Accordingly, when PZT film is used as the ferroelectric film, oxygen is depleted from the PZT film by the thermal processing in a hydrogen atmosphere because oxygen in the PZT film tends to form bonds with the hydrogen. When oxygen depletion takes place in the PZT film, good perovskite crystal structure cannot be formed, and the capacitor can not exhibit good ferroelectricity.

When PLZT is used as the material of a ferroelectric film, as in the present modification, the added La can suppress oxygen depletion from the PLZT film. Accordingly, even when thermal processing is carried out under a hydrogen atmosphere, a good perovskite crystal structure can be achieved, and the capacitor can exhibit good ferroelectricity.

The PLZT film may have composition ratios of, for example, X = 0.6 and Y = 0.01. Composition ratios of the PLZT film are not limited to any composition ratio, and can be set suitably to form a ferroelectric capacitor of required characteristics.

As described above, in the present embodiment, PLZT film is used as the ferroelectric film. Even when thermal processing is carried out under a hydrogen atmosphere, depletion of oxygen from the PLZT film can be suppressed. Accordingly, in the present modification, good perovskite crystal structure can be ensured, and a semiconductor device whose ferroelectric capacitors have good electric characteristics can be provided.

The capacitor 42e shown in FIG. 7B is characterized mainly in that intermediate layers 34a, 38a are formed of BST, and PLZT is used as the material of a ferroelectric film 36a.

For reasons described above, even when both intermediate layers 34a, 38a of BST and ferroelectric film 36a of PLZT are used, a ferroelectric capacitor using a base metal as the material of the bottom electrode 32 and the top electrode 40 can be produced.

The capacitor 42f shown in FIG. 7C is characterized mainly in that Cu is used as the material of the bottom electrode 32a and the top electrode 40a.

Cu, has low electrical resistance and high heat resistance and is a material recently much noted as an interconnection material for semiconductor devices. Accordingly, in the present modification, the top and bottom electrodes are formed integral with the interconnection layer, etc.

As described above, materials, compositions, combinations, etc. for the intermediate layers, the ferroelectric film, the bottom electrode and the top electrode can be suitably chosen so that a ferroelectric capacitor is produced which has required characteristics.

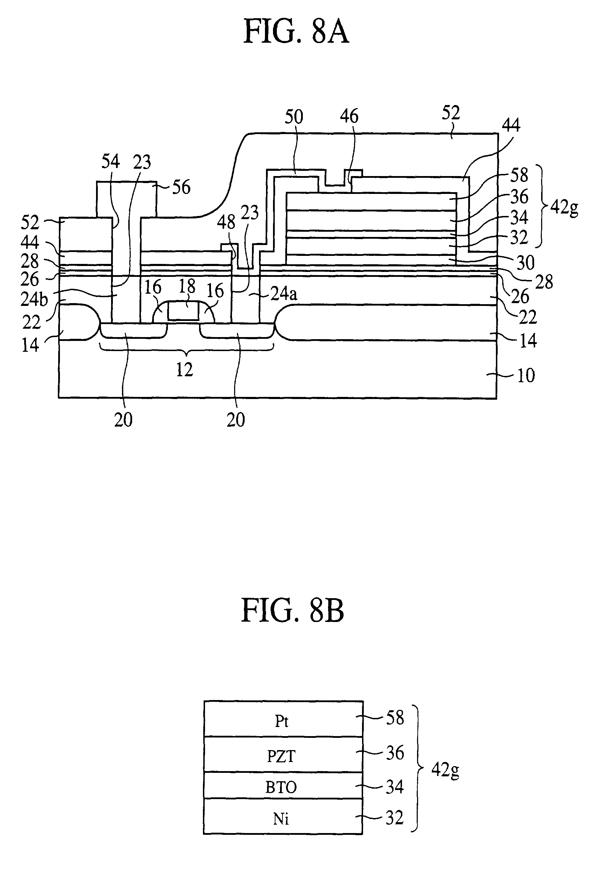

A semiconductor device according to a second embodiment of the present invention and a method for fabricating the same will now be explained with reference to FIGs. 8A to 9B.

Reference numerals from the earlier figures are used to denote like features.

The semiconductor device according to the present embodiment is characterized mainly in that the material of the bottom electrodes is Ni, and a material of the top electrodes is Pt.

As shown in FIGs. 8A and 8B, an intermediate layer 34 of BTO is formed on the bottom Ni electrode 32. A PZT ferroelectric film 36 is formed on the intermediate layer 34.

The Pt top electrode 58 is formed on the ferroelectric film 36. In the present embodiment, the use of Pt makes it unnecessary to form an intermediate layer between the ferroelectric film 36 and the top electrode 58.

The bottom electrode 32, the intermediate layer 34, the ferroelectric film 36 and the top electrode 58 together constitute a capacitor 42g for a memory device.

In the present embodiment, Ni, which is an inexpensive base metal, is used as the material of at least the bottom electrode 32. In comparison with the semiconductor device shown in FIG. 13 in which an expensive noble metal is used as the material of both the bottom and top electrodes the semiconductor device according to the present embodiment is less expensive.

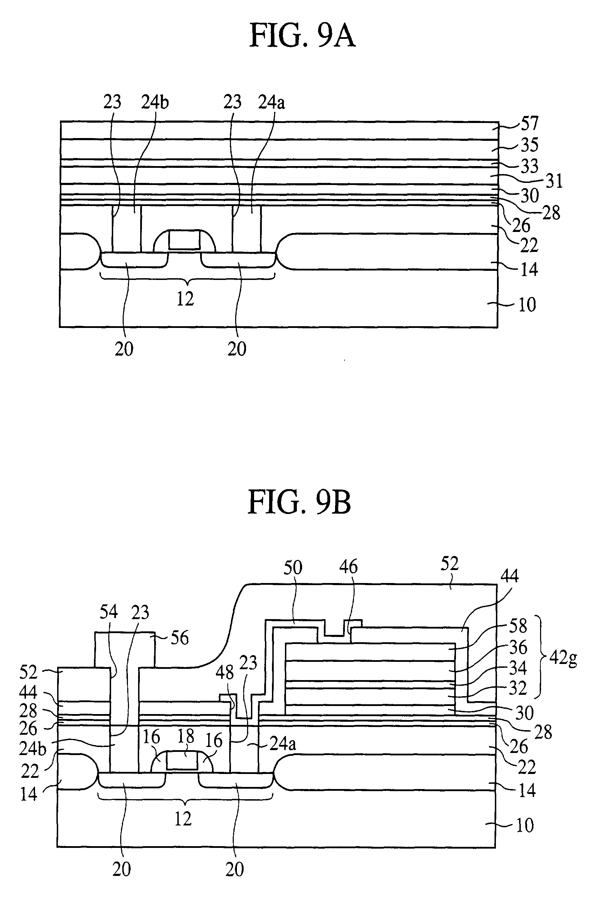

The method for fabricating the semiconductor device according to the present embodiment will be explained with reference to FIGs. 9A and 9B.

The steps up to the step of forming the BTO film 33 including the BTO film 33 forming step are the same as those of the method for fabricating the semiconductor device according to the first embodiment described with reference to FIGs. 2A to 3A, and their explanation is not repeated.

Then, in the same way as in the first embodiment, a 200 nm-thick PZT film 35 is formed on the ferroelectric film 36 without exposure to the ambient atmosphere.

Then, a 100 nm-thick Pt film 57 for forming the top electrode 58 is formed on the entire surface by sputtering without exposure to the ambient atmosphere.

The subsequent steps in fabrication of a semiconductor device are the same as those of the method for fabricating the semiconductor device according to the first embodiment shown in FIGs. 4A to 5, and their explanation is not repeated and the device of FIG. 9B, which is that shown in FIG. 8A, is obtained.

According to the present embodiment, an inexpensive base metal is used as a material of only the bottom electrode, which still makes it possible to provide a semiconductor device at less cost than the conventional semiconductor device shown in FIG. 13, in which an expensive noble metal is used as material for the bottom and top electrodes.

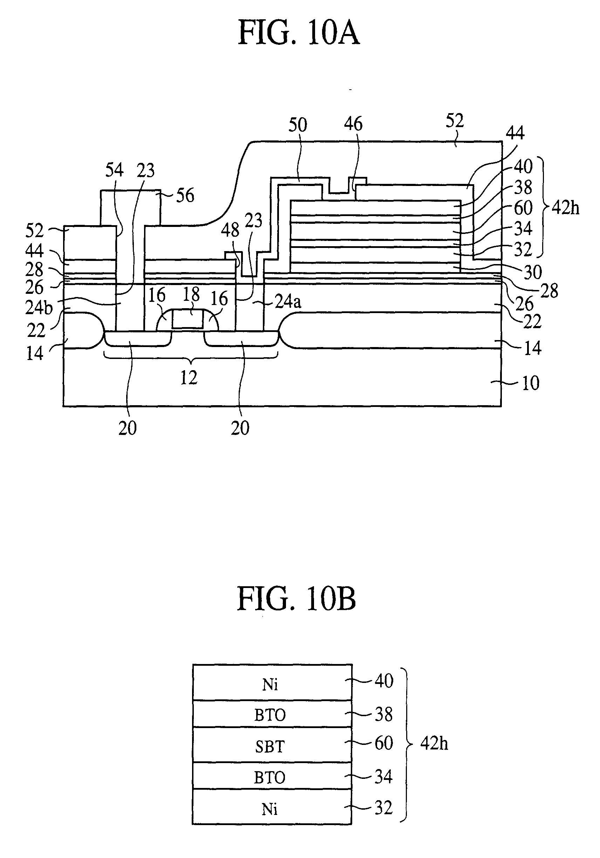

The semiconductor device according to a third embodiment of the present invention and a method for fabricating the same will be explained with reference to FIGs. 10A to 11B. Like reference numerals again denote like parts in the preceding figures, the present embodiment will be explained with reference to FIGS. 10A and 10B.

The semiconductor device shown in FIGs. 10A and 10B is characterized mainly in that a ferroelectric film 60 is provided by an (AO)₂(B_{Y-1}C_{Y}O_{3Y+1}) film in which A is at least any element from Tl, Pb, Bi, and rare earth elements; B is at least one element from Bi, Pb, Ca, Sr and Ba; C is at least one element from Ti, Nb, Ta, W, Mo, Fe, Co, Cr and Zr; and Y is any of 2, 3, 4 and 5.

With the ferroelectric film of the present embodiment, a crystal structure exhibiting good ferroelectricity can be formed, and a ferroelectric capacitor having good electric characteristics can be formed.

The above-described (AO)₂(B_{Y-1}C_{Y}O_{3Y+1}) film is exemplified by one in which A is Bi, B is Sr, C is Ta, and Y is 2, i.e. SBT(SrBi₂Ta₂O₉) film.

SBT film is a ferroelectric film having the perovskite crystal structure and Bi₂O₃ laid one on the other, i.e., a bismuth layer structure ferroelectric film.

Bismuth layer structure ferroelectric film exhibits good ferroelectricity as do lead-based oxide ferroelectric films.

Bismuth layer structure ferroelectric film, such as SBT film, can provide a ferroelectric film 60 exhibiting good ferroelectricity by forming intermediate layers 34, 38 as in the embodiments where PZT film is used, even when base metals, such as Ni, etc., are used as the bottom electrode 32 and the top electrode 40.

Even when the above-described bismuth layer structure ferroelectric film is used for the materials of the bottom and top electrodes are not narrowly limited to Pt, Ir, etc. This makes it possible to simplify the fabrication process and improve electric characteristics.

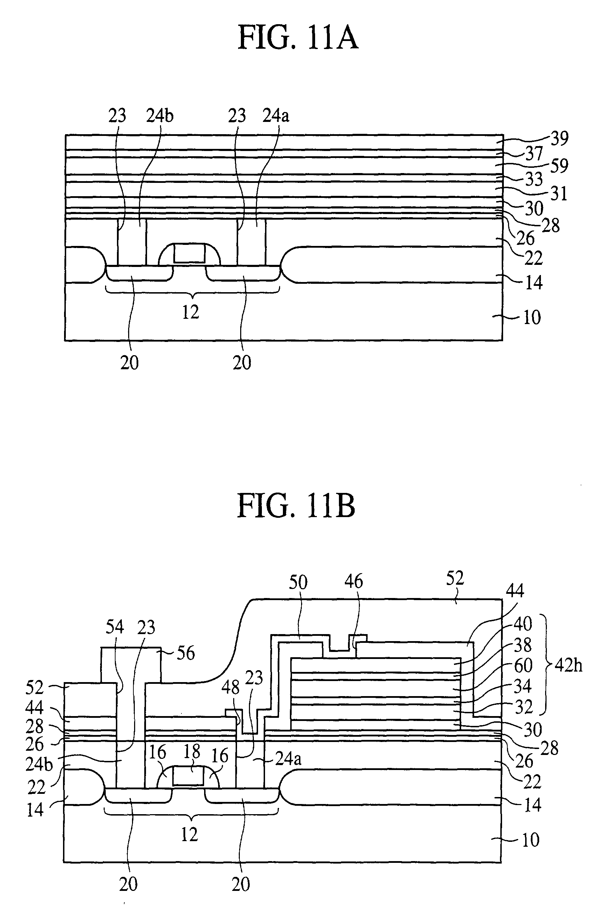

A method for fabricating a semiconductor device according to FIG. 10A will now be described with reference to FIGs. 11A and 11B.

The step of forming BTO film 31 is the same as that in the method for fabricating the semiconductor device according to the first embodiment shown in FIGs. 2A to 3A, and its explanation is not repeated.

Then, as shown in FIG. 11A, a 200 nm-thick SBT film 59 which is to constitute the ferroelectric film 60 is formed on the entire surface without exposure to the ambient atmosphere by sputtering using argon ion beams. Film forming conditions are, e.g., 10 sccm Ar gas flow rate, 3 Pa vacuum degree, 2 kW applied electric power, 5 minutes sputtering and 20 to 200 °C film forming temperature.

Next, in the same way as in the first embodiment, a BTO film 37 for providing the intermediate layer 38, and an Ni film 39 for providing the top electrode 40 are sequentially formed without exposure to the ambient atmosphere.

The subsequent steps in the semiconductor fabrication method are the same as those of the method according to the first embodiment shown in FIGs. 4A to 5, and their explanation is again not repeated.

A first modification of this latest type of semiconductor device according to the present embodiment will be explained with reference to FIG. 12A. FIG. 12A is a sectional view of the semiconductor device according to the present modification.

The capacitor shown in FIG. 12A is characterized mainly in that a ferroelectric film 60a is provided by the above-described (AO)₂(B_{Y-1}C_{Y}O_{3Y+1}) film in which A is Bi; B is Ba; C is Ti; and Y is 3, i.e., Bi₂Ba₂Ti₃O₁₂.

Bi₂Ba₂Ti₃O₁₂ like SBT film is a bismuth layer structure ferroelectric film.

Thus, even when Bi₂Ba₂Ti₃O₁₂ is used as a material of the ferroelectric film, a ferroelectric capacitor can be produced using a base metal as a material of the bottom electrode and the top electrode.

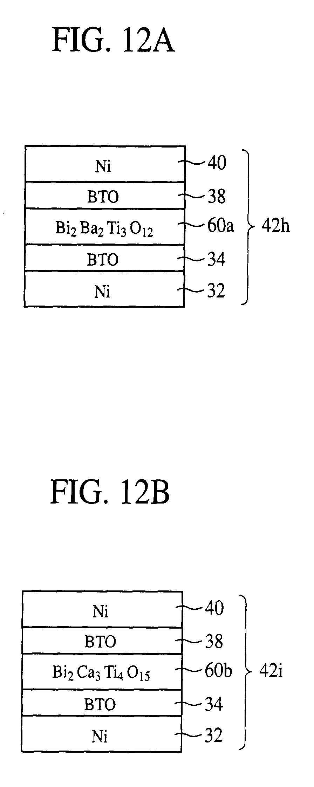

A second modification of the present embodiment will be explained with reference to FIG. 12B.

The capacitor 42i shown in FIG. 12B is characterized mainly in that a ferroelectric film 60b is provided by the above-described (AO)₂(B_{Y-1}C_{Y}O_{3Y+1}) film in which A is Bi; B is Ca; C is Ti; but Y is 4, i.e., Bi₂Ca₃Ti₄O₁₅.

Bi₂Ca₃Ti₄O₁₅, like SBT film, is a bismuth layer structure ferroelectric film.

Thus, even when Bi₂Ca₃Ti₄O₁₅ film is used as the material of the ferroelectric film, a ferroelectric capacitor using a base meal as a material of the bottom and top electrodes can be formed.

The present invention is not limited to the above-described embodiments and can cover other various modifications.

For example, in the above-described embodiments, BTO, etc. are used as the intermediate layers, but materials of the intermediate layers are not limited to the above-described materials. Any material can be used as long as the material has the above-described characteristics, i.e., the material which can be crystallized into perovskite structure even when the intermediate layers are formed on a bottom electrode of a material of weak self-orientation, can prevent the oxidation of the bottom and top electrodes that are formed of a base metal, and can suppress transition of elements in the ferroelectric film to these bottom and top electrodes.

Materials which can satisfy the above-described conditions are, e.g., materials formed of BTO with at least one additional element from Ca, Sr, Tl, Pb, Bi, rare earth elements, Nb, Ta, W, Mo, Fe, Co, Cr and Zr added. Specifically, for example, Ba (Bi_{X}Nb_{Y}Ti_{1-X-Y})O₃, Ba (Bi_{X}Ta_{Y}Ti_{1-X-Y})O₃, Ba (Bi_{X}W_{Y}Ti_{1-X-Y})O₃, Ba(Bi_{X}Mo_{Y}Ti_{1-X-Y})O₃, Ba (Bi_{X}Fe_{Y}Ti_{1-X-Y})O₃, Ba (Bi_{X}Co_{Y}Ti_{1-X-Y})O₃, Ba (Bi_{X}Cr_{Y}Ti_{1-X-Y})O₃, Ba (Bi_{X}Zr_{Y}Ti_{1-X-Y})O₃, etc. can be used as the intermediate layers. These materials may have composition ratios of, for example, X = 0.2 and Y = 0.25.

(Ba_{X}Ca_{Y}Sr_{1-X-Y})TiO₃, (Ba_{X}Tl_{Y}Sr_{1-X-Y})TiO₃, etc as materials of the intermediate layers may be used. These materials may have composition ratios of, for example, X = 0.5 and Y = 0.25. (BaₓPb₁₋ₓ)TiO₃, etc. can be used as materials of the intermediate layers. A composition ratio of these materials can be, e.g., X=0.5. Baₓ (Er_{y}Ti_{1-Y})O₃, etc. may be used as materials of the intermediate layers. These materials can have composition ratios of, for example, X = 0.5 and Y = 0.5. The above-described composition ratios can be suitably adjusted so as to give the intermediate layers of required characteristics.

Although the present invention, lead-based oxide ferroelectrics, etc. have been described for use as a material of the ferroelectric film, the material of the ferroelectric film is not limited to the materials described hereinbefore. Any other ferroelectric film can be suitably used.

In the first and the second embodiments, the lead-based oxide ferroelectrics have been illustrated by means of PZT, etc. However, the lead-based oxide ferroelectric is not limited to the materials described in the embodiments, and any other lead-based oxide ferroelectrics can be suitably used. For example, at least any element of La, Sr and Ca may be further added to PZT. For example, PLCSZT, which is a lead-based oxide ferroelectric formed of PZT with La, Ca and Sr added, can be used.

In above-described embodiments, materials of the bottom electrode and the top electrode are Ni and Cu, but any other base metals can be suitably used. One such metal is Cr.

In above-described embodiments, the materials of the bottom electrode and the top electrode are typically Cu and Ni. However, other elements may be added to the Cu or Ni. For example, at least one element from Sc, Ti, V, Cr, Mo, Fe, Co, Y, Zr, Nb, Mn, Ta, W, Ir and Pt may be added to Ni or Cu. Moreover, Cu and Ni can be added to Ni and Cu respectively.

In above-described embodiments base metals, such as Ni, etc., are used as materials of the bottom electrode and the top electrode for the purpose of reducing costs. Relatively inexpensive noble metals may be used to achieve some cost reduction. For example, Au, etc. which is less expensive than Pt, Ir, etc., can be used to thereby provide semiconductor device at lower cost than the conventional semiconductor device.

In the second embodiment, Pt is used as the material from which the top electrode is formed. Such electrode is not limited to Pt. For example, Pt alloys or Ir, Ir alloys, etc. may be used.

In the second embodiment, the bottom electrode is formed of base metal, and the top electrode is formed of noble metal. The bottom electrode may be formed of noble metal, and the top electrode is then formed of base metal, and in this case it is necessary to form an intermediate layer between the ferroelectric film and the top electrode.

In the third embodiment, bismuth layer structure ferroelectrics are exemplified by BST, etc. Bismuth layer structure ferroelectric is not limited to the materials described in the third embodiment, and any other bismuth layer structure ferroelectrics can be suitably used.

In the third embodiment, A, B, C and Y are selected to form a bismuth layer structure ferroelectric. However, A, B, C and Y are not set so as to restrictively form a bismuth layer structure ferroelectric. They may be suitably set so as to form other ferroelectrics having required characteristics.

The above-described embodiments have been explained by means of a FRAM. However, the present invention is not essentially applied to FRAM's and is applicable to any semiconductor devices using ferroelectrics. The above-described capacitor is applicable to a single capacitor. When the above-described capacitor is applied to a single capacitor, the above-described function and effects can be provided.

In the above-described embodiments, the intermediate layers and the ferroelectric films are formed by sputtering and the sol-gel process. However, the intermediate layers and the ferroelectric films may be formed not only by sputtering and sol-gel process but also by other film forming processes.

In the above-described embodiments, an inert gas used in forming the intermediate layers and the ferroelectric films is argon gas. However, not only argon gas but also any other inert gas can be used, and helium gas, neon gas, krypton gas, nitrogen gas, xenon gas, their mixed gases or others, for example, can be suitably used.

## Claims

1. A semiconductor device comprising a first electrode, a ferroelectric film formed above the first electrode, and a second electrode formed above the ferroelectric film, the device further comprising an intermediate layer of a perovskite crystal structure formed at at least one of the boundary between the first electrode and the ferroelectric film, and the boundary between the ferroelectric film and the second electrode.

2. A semiconductor device according to claim 1, wherein the intermediate layer is a BaTiO₃, SrTiO₃, or CaTiO₃.

3. A semiconductor device according to claim 2, wherein the intermediate layer further contains at least one element from Ca, Sr, Tl, Pb, Bi, rare earth elements Nb, Ta, W, Mo, Fe, Co ,Cr, and Zr.

4. A semiconductor device according to claim 1, wherein the first electrode and/or the second electrode is base metal.

5. A semiconductor device according to claim 4, wherein the base metal is Ni, Cu or Cr.

6. A semiconductor device according to any one of claims 1-5 wherein the ferroelectric film is lead-based oxide ferroelectric film.

7. A semiconductor device according to claim 6, wherein the lead-based oxide ferroelectric film is PbZr_{X}Ti_{1-X}O₃ film.

8. A semiconductor device according to claim 7, wherein the PbZr_{X}Ti_{1-X}O₃ film further contains at least any one of elements La, Sr and Ca.

9. A semiconductor device according to any one of claims 1 to 5, wherein the ferroelectric film is (AO)₂(B_{Y-1}C_{Y}O_{3Y+1}) film wherein A is at least one element from Tl, Pb, Bi and rare earth element; B is at least one element from Bi, Pb, Ca, Sr and Ba; C is at least one element from Ti, Nb, Ta, W, Mo, Fe, Co, Cr and Zr; and Y is any of 2, 3, 4 and 5.

10. A semiconductor device according to claim 9, wherein the ferroelectric film is bismuth layer structure ferroelectric film.

11. A semiconductor device according to claim 10, wherein the bismuth layer structure ferroelectric film is SrBi₂Ta₂O₉ film, Bi₂Ba₂Ti₃O₁₂ film or Bi₂Ca₃Ti₄O₁₅ film.

12. A semiconductor device according to any preceding claim having a transistor connected to the first electrode or the second electrode.

13. A method for fabricating a semiconductor device comprising the step of forming a first electrode, the step of forming a ferroelectric film above the first electrode, and the step of forming a second electrode above the ferroelectric film, further comprising the step of forming an intermediate layer which is crystallizable into perovskite structure after the step of forming the first electrode and before the step of forming the ferroelectric film and/or after the step of forming the ferroelectric film and before the step of forming the second electrode.

14. A method for fabricating a semiconductor device according to claim 13, wherein in the step of forming the intermediate layer, the intermediate layer is formed in an inert atmosphere.

15. A method for fabricating a semiconductor device according to claim 13 or 14, wherein the intermediate layer and the ferroelectric film are formed without there being exposure to ambient atmosphere.
